## Europäisches Patentamt

## European Patent Office

## Office européen des brevets

(11) Publication number: **0 199 440 B1**

(12) **EUROPEAN PATENT SPECIFICATION**

(45) Date of publication of the patent specification:
21.06.89

(51) Int. Cl.⁴: **C30B 7/10, C30B 29/22**

(21) Application number: 86301515.2

(22) Date of filing: 04.03.86

(54) A method of manufacturing a single crystal of BaPb1-xBix03.

(30) Priority: 18.03.85 JP 53891/85

(43) Date of publication of application:
29.10.86 Bulletin 86/44

(45) Publication of the grant of the patent:
21.06.89 Bulletin 89/25

(84) Designated Contracting States:
DE FR GB

(56) References cited:
JOURNAL OF CRYSTAL GROWTH, vol. 66, no. 1,
January/February 1984, pages 228-230, Amsterdam, NL;
A. KATSUI et al.: "Growth of superconducting
Ba(Pb,Bi)O3 crystals"

(73) Proprietor: SEIKO INSTRUMENTS INC., 31-1,
Kameido 6-chome Koto-ku, Tokyo 136(JP)
Proprietor: Hirano, Shinichi, 2-66, Yada-cho Higashi-ku,
Nagoya-shi Aichi(JP)
Proprietor: Naka, Shigeharu, 1-22-25, Kasumigaoka
Chigusa-ku, Nagoya-shi Aichi(JP)

(72) Inventor: Hirano, Shinichi, 2-66, Yada-cho Higashi-ku,
Nagoya-shi Aichi(JP)
Inventor: Naka, Shigeharu, 1-11-25, Kasumigaoka
Chigusa-ku, Nagoya-shi Aichi(JP)

(74) Representative: Caro, William Egerton et al, J. MILLER &
CO. Lincoln House 296-302 High Holborn, London
WC1V 7JH(GB)

**Description**

This invention relates to methods of manufacturing single crystals of $BaPb_{1-x}Bi_xO_3$. Such single crystals are useful as super-conductive elements, semi-conductive elements or optical electronics elements widely used in the electronics industry.

$BaPb_{1-x}Bi_xO_3$ (barium-lead-bismuth oxide) with Perovskite structure, shows super-conductivity in the range of $0.05 \leq x \leq 0.30$, semi-metallic characteristics in the range range of $x < 0.05$, and semi-conductivity in the range of $0.30 < x$. The super-conductive transition temperature Tc is a maximum (13°K) when x is approximately 0.25. This is the highest known temperature at which an oxide material that does not include transition metal elements exhibits super-conductivity. Attention has focussed on these barium-lead-bismuth oxide compounds because of their super-conductivity and because the super-conductivity depends upon their exact composition. Moreover, compounds of this type can be made of semi-metallic materials whose carrier density is $\underline{n}$ is small, and can be made as super-conductors whose electron carrier density N (o) at the Fermi surface is very small indeed. Therefore, these compounds have a resistance rate that is several orders of magnitude greater than ordinary metal super-conductors, at temperatures slightly higher than Tc. This characteristic is required for materials used for super-conductive switches. When barium-lead-bismuth oxide compounds are formed as single crystals they are relatively stable and crystals which are transparent in the infra-red region, can be expected to be useful for optical electronics elements at very low temperatures.

Growing single crystals of $BaPb_{1-x}Bi_xO_3$ has been tried utilising a flux. In one method, potassium chloride (KCl) is favoured because because $BaPb_{1-x}Bi_xO_3$ dissolves in it. However, to melt KCl and to dissolve $BaPb_{1-x}Bi_xO_3$ in it, a high temperature of about 1000°C is necesary, and thus potassium ions will be incorporated in the resulting single crystal of $BaPb_{1-x}Bi_xO_3$. Consequently, the impurity density increases. As the crystal grows at a temperature higher than the transition point (500°C to 600°C) of $BaPb_{1-x}Bi_xO_3$, a crystal phase transition occurs on cooling, and therefore, strains occur within the crystal.

In another method, a non-stoichiometric solution of $PbO_2-Bi_2O_3-BaPbO_3$ is used. In this case, there is an advantage that the inclusion of impurities will be greatly reduced, but, when crystallising from a non-stoichiometric solution, control of the composition, i.e. x, that determines the characteristics of the resulting crystal, will be very difficult. Also, strains accompanying the phase transition occur as stated above.

The above methods are disclosed in Akinori Katsui; Japanese Journal of Applied Physics Vol. 21 No. 9 (1982) Page 553 to 554.

With the conventional methods of manufacturing single crystals of $BaPb_{1-x}Bi_xO_3$, the impurity density within the material is relatively large and also, the change of composition x is relatively large. Also the conventional methods have serious disadvantages, i.e. the reproducability of the characteristics of the single crystal are poor and as a result of the phase transition heat strains remain in the crystal because high temperatures of about 1000°C are used. These disadvantages are primary factors that prevent sharp transition to the super-conductivity of the resulting single crystal.

The above disadvantages of the prior art methods are caused by crystallisation from a solution which has high viscosity and large composition change, at a very high temperature.

The present invention seeks to provide a method of manufacturing a single crystal of $BaPb_{1-x}Bi_xO_3$ using a hydrothermal process to allow the crystal to grow at relatively low temperatures below 500°C, so that it is possible to improve the characteristics of the resultant single crystal avoiding its phase transition.

According to the present invention there is provided a method of manufacturing a single crystal of $BaPb_{1-x}Bi_xO_3$ by dissolving $BaPb_{1-x}Bi_xO_3$ in an aqueous solution and subjecting the resulting solution to a hydrothermal process at a predetermined pressure and a temperature below 500°C during which process crystallisation takes place.

The aqueous solution may be an alkali chloride, e.g. sodium chloride or potassium chloride or an alkali hydroxide, e.g. sodium hydroxide.

The aqueous solution may include an oxygen-generating compound such as a peroxide compound or potassium chlorate.

In one embodiment a single crystal of $BaPb_{1-x}Bi_xO_3$ is formed as a thin film on a substrate. The substrate may be $SrTiO_3$.

The invention is illustrated, merely by way of example, in the accompanying drawings, in which: –

Figure 1 is a sectional view of an autoclave used in Example 3 of a method according to the present invention;

Figure 2 is a characteristic diagram showing the variation of cubic imitated lattice constants $\underline{a}$ corresponding to composition $\underline{x}$ of a single crystal of $BaPb_{1-x}Bi_xO_3$ made by a method according to the present invention; and

Figure 3 is a sectional diagram showing the structure of an autoclave used in Example 1 of a method according to the present invention.

In the hydrothermal process of the invention, the starting material is dissolved in a solution of an appropriate solvent at appropriate temperature and pressure, and the intended crystal is grown on a suitable substrate. The growth temperature is generally from 300°C to below 500°C, this temperature being very low compared to the temperature used in the prior art. By selecting a suitable combination of temperature, pressure, and the appropriate solvent, and controlling the starting material and the substrate on which the crystal is grown, a single crystal with very little defects can be produced.

The following are Examples of the present invention.

Example 1

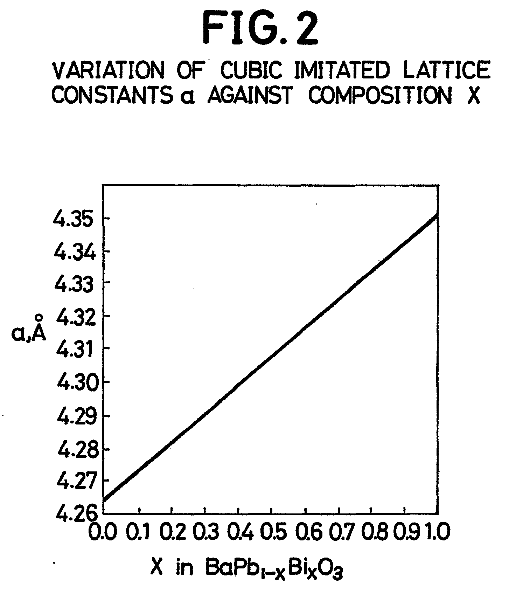

Commercially available high purity $BaCO_3$, $PbO_2$, $Bi_2O_3$ were used as the starting materials and adjustment of the amount thereof was effected so that the super-conductive composition $BaPb_{1-x}Bi_xO_3$ has x = 0.2, x = 0.3. After this adjustment, the starting materials were blended in a mortar and baked for one whole day at 850°C in a stream of oxygen. To complete the reaction the above was repeated. When the resulting powder samples were examined using an X-ray diffractometer, they were observed to be $BaPb_{1-x}Bi_xO_3$ in a single phase. From measurements made, the relation between lattice constant $\underline{a}$ (cubic imitated lattice constant) and composition $\underline{x}$ was found and this is illustrated in Figure 2. From Figure 2 it will be seen that the lattice constant $\underline{a}$ corresponding to $\underline{x}$ are respectively x = 0.21, x = 0.27.

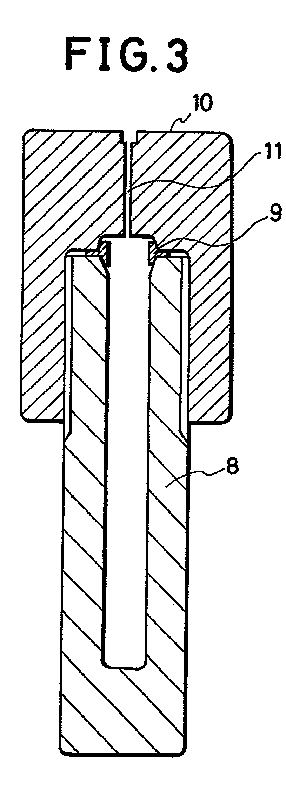

For the hydrothermal process, a test tube type autoclave 8 of stelite 25 was utilised. Figure 3 is a sectional diagram showing the structure of the autoclave. The autoclave 8 has a cover 10 with a seal ring 9. The measurement of the temperature within the autoclave is through a temperature measuring hole 11. A gold capsule with a diameter of 3mm or 5mm was utilised in the autoclave, a powder sample of $BaPb_{1-x}Bi_xO_3$ produced as above and a solvent being poured into the gold capsule. In this example, distilled water filled the inside of the autoclave, to maintain a pressure balance between the inner and outer surfaces of the gold capsule.

As the solvent, 3 mol NaCl aqueous solution, 3 mol KCl aqueous solution, and 3 mol NaOH aqueous solution were used with different samples. The hydrothermal process was conducted for 7 days at a pressure of 1000 Kg/cm², at a temperature of 410 to 450°C. The results are shown in Table 1.

| Sample No. | Density and the type of solvents | Whether the crystallization occurs or not |
|---|---|---|
| 1 | 3 mol NaCl aqueous solution | 0 |
| 2 | 3 mol KCl aqueous solution | 0 |
| 3 | 3 mol NaOH aqueous solution | 0 |

temperature 410 to 450°C
pressure 1000 kg/cm²
growth period 7 days

It was observed that, with any of the above solvents, the samples were dissolved and re-precipitated, and crystals were grown. The same result was obtained with any of the samples of composition x = 0.21, x = 0.27. When each of the resulting crystals was powdered and identified using an X-ray diffractometer, it was observed that all were $BaPb_{1-x}Bi_xO_3$ single phase. The crystals with the best crystallisation characteristic and growth speed were obtained using KCl aqueous solution as the solvent.

Example 2

Example 1 was repeated utilising 4.5 mol KCl aqueous solution as the solvent, at a temperature of 300 to 450°C. The results are shown in Table 2.

Table 2

| Sample No. | Temperature of the gold capsule | | Whether the crystallization occurs or not |
|---|---|---|---|
| | upper part | lower part | |
| 4 | 320°C | 350°C | x |
| 5 | 360°C | 400°C | 0 |
| 6 | 410°C | 450°C | 0 |

solvent = 4.5 mol KCl aqueous solution
pressure = 1000 kg/cm$^2$
growth period = 7 days

solvent = 4.5 mol KCl aqueous solution
pressure = 1000 Kg/cm$^2$
growth period = 7 days

When the temperature was 350°C, neither dissolution nor re-crystallisation was observed and the sample remained in the lower part of the gold capsule. However, when the temperature was above 400°C, the sample dissolved and re-crystallised, crystals with a diameter of about 2mm being grown. The same result can be obtained with samples with composition x = 0.21, or x = 0.27. When the temperature was 450°C, even larger crystals were obtained but occasionally twin crystals were produced, the crystal surface being coarse with many secondary grains attached onto it. These defects are thought to occur because secondary nucleation generates upon cooling. When the resulting crystals were powdered and identified using an X-ray diffractometer, it was observed that they were all $BaPb_{1-x}Bi_xO_3$ single phase. The composition could be determined using the graph shown in Figure 2 viz:

Table 3

| Composition x of adjustment sample | Composition x of the crystal after the hydrothermal process |
|---|---|
| 0.21 | 0.20 |
| 0.27 | 0.25 |
| x depends on $BaPb_{1-x}Bi_xO_3$ | |

x depends on $BaPb_{1-x}Bi_xO_3$

Therefore, x = 0.21 of the powder sample changed to x = 0.20 in the single crystal and x = 0.27 changed to x = 0.25, but the change was minute for practical purposes.

Example 3

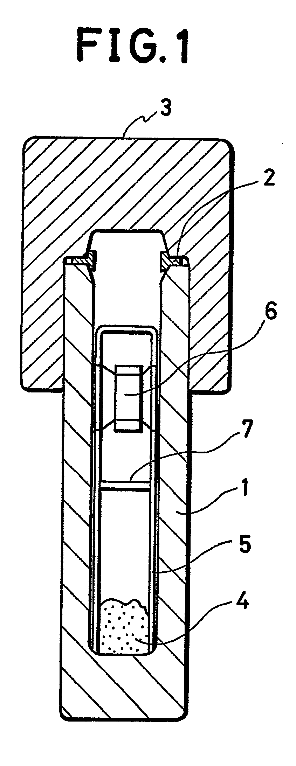

Figure 1 shows a test-tube type autoclave 1 used in this Example. The autoclave is of stelite 25, but had a platinum inner lining to avoid contamination through impurities. The autoclave 1 was pressure sealed with a cover 3, through a seal ring 2. A nutrient 4 was mounted at the bottom of the autoclave. This nutrient 4 was obtained by grinding and powdering $BaPb_{1-x}Bi_xO_3$ obtained as in Example 2, and grinding and powdering crystals of either x = 0.20 or x = 0.25. Then a substrate 6 was mounted above the nutrient 4, in a substrate support frame 5. The substrate 6 was a crystal of $SrTiO_3$ which has a similar crystal structure and similar atom bond length to $BaPb_{1-x}Bi_xO_3$, the (001) crystal surface being used. Instead of the (001) surface, the (111) surface or (110) surface could also be used. A buffer plate 7 was mounted on the substrate support frame 5 between the nutrient 4 and the substrate 6. 4.5 mol of aqueous KCl as a solvent was charged in the autoclave in an amount such that a predetermined temperature and a predetermined pressure could subsequently be obtained. A hydrothermal process under the same conditions as in Table 2 of Example 2 was initiated. These conditions were:
temperature of substrate 6 = 360°C
temperature of the nutrient 4 = 400°C
solvent = 4.5 mol aqueous KCl solution
pressure = 1000 Kg/cm$^2$
growth period = 7 days.

After completion of the hydrothermal process, the autoclave was rapidly cooled, to prevent the generation of secondary nucleation.

As a result, a thin film with a uniform thickness was formed on the substrate 6. When this thin film was examined using an X-ray diffractometer as in Example 1, it was identified as a single crystal of $BaPb_{1-x}Bi_xO_3$. The single crystal has x = 0.20, x = 0.24 respectively, and no large change was observed as compared to the composition of the nutrient. When the super-conductive characteristic of the $BaPb_{1-x}Bi_xO_3$

thin film at x = 0.24 was measured, it was confirmed that it showed super-conductivity when the super-conductive transition temperature was in the range of 10.0°K to 11.7°K.

<u>Example 4</u>

Example 4 was similar to Example 3 but a different solvent was used. The conditions were as follows:
temperature of the substrate 6 = 360°C
temperature of the nutrient 4 = 400°C
solvent = aqueous solution which was 4.5 mol aqueous KCl solution to which 2% of the total weight of 2.0 mol $KClO_3$ aqueous solution was added
pressure = 1000 Kg/cm²
growth period = 7 days.

As in Example 3, the autoclave was quenched after completion of the hydrothermal process. In this Example, a thin film was also formed on the (001) surface of the $SrTiO_3$ substrate. This thin film was confirmed using an X-ray diffractometer to be $BaPb_{1-x}Bi_xO_3$, and it showed super-conductivity in the range of 10.0°K to 11.7°K but compared to Example 3, its super-conductivity was clearer and better defined. This is thought to be due to the addition of an oxygen-generating compound such as peroxide or potassium chlorate ($KClO_3$) to the solution and the active oxygen thus generated. This generated oxygen prevents any oxygen deficiency inside the crystal as it is grown, and the atomic valence in the crystal is automatically controlled. Thus the mobility characteristic of the crystal is improved. Also in the case of using potassium chlorate as the oxygen-generating compound after it has given up its oxygen, it becomes potassium chloride and forms part of the aqueous solvent. It thus has the advantage that it does not create impurities in the crystals grown. However, potassium chlorate is not the only oxygen-generating compound that can be used. Potassium perchloric acid can be utilised, in appropriate amounts.

As stated above, compared to the conventional KCl flux method or the crystallisation method from a non-stoichiometric solution, with the present invention there is a very low level of potassium ion impurities in the crystals because this process utilised low-viscosity KCl aqueous solution at a relatively low temperature of 400 to 450°C. Also, as the appearance of super-conductivity of the single crystals of $BaPb_{1-x}Bi_xO_3$ is important, reproducibility of compositions with a given value of x is very efficient. Consequently, the present invention has a big industrial advantage in that single crystals of the intended composition x are easily manufactured with suitable adjustment to the start materials. Similarly, as the process is carried out at a relatively low temperature of about 400°C, defects such as strain or heat strain accompanying the phase transition are very small. Therefore, a more perfect crystal can be obtained, and at the same time, by adding oxygen-generating compounds such as peroxide compounds to the solvent, the oxygen deficiency is reduced and the atomic valence is controlled. Consequently, it is possible to improve crystal perfection.

With any method, by obtaining complete crystals with uniform composition x, the improvement of super-conductivity is confirmed, and its effect is very large.

Also, on the industrial side, because the process is carried out at a temperature of approximately 400°C, it is very easy to develop an industrial technique for manufacturing industrially single crystals using a hydrothermal process.

It will be appreciated from the above discussion that $BaPb_{1-x}Bi_xO_3$ crystals valuable as super-conductive elements or optical electronics elements, with more perfect characteristics and fewer defects can be obtained.

**Claims**

1. A method of manufacturing a single crystal of $BaPb_{1-x}Bi_xO_3$ by dissolving $BaPb_{1-x}Bi_xO_3$ in an aqueous solution and subjecting the resulting solution to a hydrothermal process at a predetermined temperature and pressure.

2. A method as claimed in claim 1 in which the aqueous solution is an alkali chloride or an alkali hydroxide.

3. A method as claimed in claim 2 in which the alkali hydroxide is sodium hydroxide.

4. A method as claimed in claim 2 in which the alkali chloride is sodium chloride or potassium chloride.

5. A method as claimed in any preceding claim in which the aqueous solution includes an oxygen-generating compound.

6. A method as claimed in claim 5 in which the oxygen-generating compound is a peroxide compound.

7. A method as claimed in claim 5 in which the oxygen-generating compound is potassium chlorate.

8. A method as claimed in any preceding claim in which a single crystal of $BaPb_{1-x}Bi_xO_3$ is formed as a thin film on a substrate.

9. A method as claimed in claim 8 in which the substrate is $SrTiO_3$.

**Patentansprüche**

1. Verfahren zur Herstellung eines Einkristalls aus BaPb$_{1-x}$Bi$_x$O$_3$, indem man BaPb$_{1-x}$Bi$_x$O$_3$ in einer wäßrigen Lösung auflöst und die entstehende Lösung einem hydrothermalen Verfahren einem vorbestimmten Druck und einer Temperatur unterhalb 500°C unterwirft, wobei während dieses Verfahrens die Kristallisation stattfindet.

2. Verfahren nach Anspruch 1, worin die wäßrige Lösung ein Alkalichlorid oder ein Alkalihydroxid ist.

3. Verfahren nach Anspruch 2, worin das Alkalihydroxid Natriumhydroxid ist.

4. Verfahren nach Anspruch 2, worin das Alkalichlorid Natriumchlorid oder Kaliumchlorid ist.

5. Verfahren nach einem der vorhergehenden Ansprüche, worin die wäßrige Lösung eine Sauerstoff erzeugende Verbindung einschließt.

6. Verfahren nach Anspruch 5, worin die Sauerstoff erzeugende Verbindung eine Peroxidverbindung ist.

7. Verfahren nach Anspruch 5, worin die Sauerstoff erzeugende Verbindung Kaliumchlorat ist.

8. Verfahren nach einem der vorhergehenden Ansprüche, worin ein Einkristall aus BaPb$_{1-x}$Bi$_x$O$_3$ als dünner Film auf einem Substrat gebildet wird.

9. Verfahren nach Anspruch 8, worin das Substrat SrTiO$_3$ ist.

**Revendications**

1. Un procédé de fabrication d'un monocristal de BaPb$_{1-x}$Bi$_x$O$_3$ par dissolution de BaPb$_{1-x}$Bi$_x$O$_3$ dans une solution aqueuse et soumission de la solution résultante à un procédé hydrothermique à une pression prédéterminée et à une température inférieure à 500°C, procédé durant lequel la cristallisation a lieu.

2. Un procédé selon la revendication 1, selon lequel la solution aqueuse est un chlorure de métal alcalin ou un hydroxyde de métal alcalin.

3. Un procédé selon la revendication 2, selon lequel l'hydroxyde de métal alcalin est l'hydroxyde de sodium.

4. Un procédé selon la revendication 2, selon lequel le chlorure de métal alcalin est le chlorure de sodium ou le chlorure de potassium.

5. Un procédé selon l'une quelconque des revendications précédentes, selon lequel la solution aqueuse inclut un composé générateur d'oxygène.

6. Un procédé selon la revendication 5, selon lequel le composé générateur d'oxygène est un composé peroxyde.

7. Un procédé selon la revendication 5, selon lequel le composé générateur d'oxygène est le chlorate de potassium.

8. Un procédé selon l'une quelconque des revendications précédentes, selon lequel un monocristal de BaPb$_{1-x}$Bi$_x$O$_3$ est formé sous la forme d'un film mince sur un substrat.

9. Un procédé selon la revendication 8, selon lequel le substrat est du SrTiO$_3$.

# FIG.1

# FIG. 2

## VARIATION OF CUBIC IMITATED LATTICE CONSTANTS a AGAINST COMPOSITION X

X in $BaPb_{1-x}Bi_xO_3$

# FIG.3